# EUROPÄISCHE PATENTSCHRIFT

(11) **EP 3 469 629 B1**
(45) Veröffentlichungstag und Bekanntmachung des Hinweises auf die Patenterteilung: **03.09.2025**
(21) Anmeldenummer: 16816220.4
(22) Anmeldetag: 02.12.2016
(51) Int. Cl.: H01L 23/552, H01L 23/367, H01L 23/538, H01L 25/10, H01L 21/60, H01L 21/98, H01L 23/16

(54) **EINE VIELZAHL VON MODULEN**
A PLURALITY OF MODULES
UN GRAND NOMBRE DE MODULES

(30) Priorität: 14.06.2016 DE 102016110862
(43) Veröffentlichungstag der Anmeldung: 17.04.2019
(73) Patentinhaber: SnapTrack, Inc., San Diego, CA 92121 (US)
(72) Erfinder: FRANZ, Andreas, 85591 Vaterstetten (DE); PORTMANN, Jürgen, 81677 München (DE); REITLINGER, Claus, 85283 Wolnzach (DE); KIEFL, Stefan, 80992 München (DE); FREUDENBERG, Oliver, 85604 Zorneding (DE); WEIDNER, Karl, 81245 München (DE)
(74) Vertreter: Bardehle Pagenberg Partnerschaft mbB Patentanwälte Rechtsanwälte
(86) Internationale Anmeldenummer: PCT/EP2016/079607
(87) Internationale Veröffentlichungsnummer: WO 2017/215771

(56) Entgegenhaltungen:
- JP-A- 2006 186 091
- JP-A- 2006 186 091
- US-A1- 2009 236 731
- US-A1- 2009 236 731
- US-A1- 2014 036 464
- US-A1- 2014 036 464

## Beschreibung

Die vorliegende Erfindung betrifft eine Vielzahl von Modulen.

Bei der Entwicklung von Modulen wird eine kontinuierliche Verkleinerung der Module bei gleichzeitig steigendem Integrationsgrad sowie gleichzeitiger Zunahme der Funktionalität der Module angestrebt. Für die zukünftig fortschreitende Integration von elektrischen und elektronischen Komponenten in einem Modul ist der zur Verfügung stehende Raum sehr begrenzt. Daher ist die Entwicklung neuartiger Aufbau- und Verbindungstechniken erforderlich.

US 2009/236731 A1 betrifft ein stapelbares integriertes Schaltkreis-Paketsystem, aufweisend Anbringen einer integrierten Schaltkreisvorrichtung über einem Paketträger, Anbringen eines Versteifers über dem Paketträger und Anbringen eines anbringbaren Paketträgers über dem Versteifer mit einer vertikalen Lücke zwischen der integrierten Schaltkreisvorrichtung und dem anbringbaren Paketträger.

JP 2006 186091 A betrifft eine Halbleitervorrichtung die durch Stapeln von Substraten gebildet wird. Ein Halbleiterbauelement umfasst ein erstes Substrat, das ein erstes Bauelement aufweist, während auf der Oberfläche eine erste Bump-Elektrode ausgebildet ist; ein zweites Substrat, das ein zweites Bauelement aufweist, während auf der Oberfläche eine zweite Bump-Elektrode ausgebildet ist, und die erste Bump-Elektrode ist mit der zweiten Bump-Elektrode zur Laminierung auf dem ersten Substrat 2 verbunden; und ein erstes Versiegelungsverbindungsmaterial und ein zweites Versiegelungsverbindungsmaterial, die zwischen dem ersten Substrat und dem zweiten Substrat angeordnet sind, um diese zu verbinden, während sie im verbundenen Zustand die erste Bump-Elektrode und die zweite Bump-Elektrode umgeben und den Innenraum luftdicht abdichten.

Die Aufgabe der vorliegenden Erfindung ist es, ein verbessertes Modul bereitzustellen, das beispielsweise eine weitere Erhöhung eines Integrationsgrads des Moduls erlaubt. Das Modul könnte beispielsweise für den Einsatz in einem mobilen Endgerät, in einer Industrieapplikation oder im Automotive-Bereich geeignet sein. Eine weitere Aufgabe besteht darin, eine Aufbau- und Verbindungstechnik anzugeben, die es ermöglicht, ein solches Modul in einfacher Weise herzustellen.

Die oben genannte Aufgabe wird durch ein Modul gemäß dem vorliegenden Anspruch 1 gelöst.

Es wird ein Modul vorgeschlagen, das einen unteren Modulbestandteil, der ein Material aufweist, in das zumindest ein erstes Bauelement eingebettet ist, und einen oberen Modulbestandteil, der ein Material aufweist, in das zumindest ein zweites Bauelement eingebettet ist, aufweist, wobei der obere Modulbestandteil und der untere Modulbestandteil übereinander gestapelt sind und der untere und der obere Modulbestandteil elektrisch miteinander kontaktiert sind und mechanisch miteinander verbunden sind.

Das Modul ist nicht auf eine Ausgestaltung mit lediglich zwei Modulbestandteilen beschränkt. Es kann vielmehr weitere Modulbestandteile aufweisen, die übereinandergestapelt sind und die miteinander elektrisch kontaktiert und mechanisch verbunden sind.

Durch das Übereinanderstapeln der Modulbestandteile kann das Modul seinen Integrationsgrad in eine dritte Dimension, nämlich die Höhe, erhöhen. Jeder der Modulbestandteile kann dabei als eine Technologieplattform wirken, in die beliebige Bauelemente eingebettet sein können. Die Bauelemente können derart in das jeweilige Material eingebettet sein, dass keine zusätzlichen Lötstellen zur Kontaktierung der Bauelemente erforderlich sind. Auf diese Weise kann der Platzbedarf weiter reduziert werden.

Das Übereinanderstapeln der Modulbestandteile kann es ermöglichen, ein Modul mit kurzen Signalwegen bei geringem Leistungsverbrauch zu erzeugen, wodurch parasitäre Induktivitäten reduziert werden können. Beispielsweise kann es bei Modulen, deren Bauelemente einen Filter ausbilden, dadurch ermöglicht werden, die Filtereigenschaften zu verbessern.

Die Modulbestandteile können als Technologieplattformen ausgestaltet sein, in die verschiedenste Bauelemente integriert werden können, so dass das Modul zur Standardisierung genutzt werden kann, da verschiedene Typen von Bauelementen jeweils in miteinander verbindbare Modulbestandteile eingebettet werden können.

Bei dem Material, das der untere und der obere Modulbestandteil aufweisen, kann es sich beispielsweise um ein Molding-Material handeln. Das Molding-Material kann dabei derart gewählt werden, dass es zu den eingebetteten Bauelementen passt. Beispielsweise können das Molding-Material und die Bauelemente einen sehr ähnlichen thermischen Ausdehnungskoeffizienten aufweisen, um zu vermeiden, dass es bei Temperaturschwankungen zu mechanischen Spannungen kommt. Bei dem Material kann es sich alternativ auch um ein Prepregmaterial (Prepreg = Preimpregnated Fibres, zu Deutsch vorimprägnierte Fasern) handeln. Das Prepregmaterial kann durch einen Press oder Laminiervorgang aufgebracht werden. Diese Materialien können in einem Press- und/oder Laminiervorgang blasenfrei aufgebracht werden.

Alternativ kann es sich bei dem Material um ein Glassubstrat, ein Keramiksubstrat, ein PCB Substrat (PCB = Polychlorierte Biphenyle), das ein- oder beidseitig Kupfer-kaschiert sein kann, handeln.

Das Material des unteren Modulbestandteils und das Material des oberen Modulbestandteils können identisch sein. Es ist jedoch auch möglich, für den unteren und den oberen Modulbestandteil verschiedene Materialien zu verwenden. Dabei kann für jeden der beiden Modulbestandteile jeweils eins der oben genannten Materialien ausgewählt werden.

Als Modul kann hier eine Einheit bezeichnet werden, die zumindest zwei Bauelemente aufweist und die in einer Schaltungsanordnung verbaut werden kann. Das Modul kann ein Gehäuse aufweisen, in dem die Modulbestandteile verkapselt sind. Das Modul kann als Ganzes auf eine Leiterplatine aufgesetzt werden und mit dieser elektrisch kontaktiert werden.

Zumindest einer der Modulbestandteile weist auf einer dem jeweils anderen Modulbestandteil zugewandten Seite eine Umverdrahtungslage auf, die eine Metallschicht aufweist, über die die Modulbestandteile miteinander elektrisch kontaktiert sind.

Die Umverdrahtungslage kann ein- oder mehrlagig sein. Die Umverdrahtungslage kann beispielsweise mittels eines Fotolithografieverfahrens hergestellt werden. Alternativ kann die Umverdrahtungslage auch mittels zweidimensionalen oder dreidimensionalen Druckprozessen oder über eine Laserstrukturierung, beispielsweise durch LDI (= Laser Direct Imaging), gefertigt werden. LDI ist ein Verfahren, bei dem mittels eines Lasers fotosensitive Materialien ausgehärtet werden. Die Metallschicht der Umverdrahtungslage kann auch nachträglich aufgedickt werden, beispielsweise durch galvanische oder chemische Abscheideprozesse.

Ferner ist die Metallschicht mit dem in den jeweiligen Modulbestandteil eingebetteten Bauelement elektrisch kontaktiert. Dementsprechend kann das Bauelement über die Umverdrahtungslage mit Bauelementen des jeweils anderen Modulbestandteils kontaktiert werden.

Die Metallschicht in der Umverdrahtungslage kann es ermöglichen, einen Kontakt des Bauelements, das in dem Modulbestandteil angeordnet ist, mit Bezug auf seine Position an der Ober- oder Unterseite des Modulbestandteils zu verlegen. Auf diese Weise können die Kontakte der einzelnen Bauelemente so angeordnet werden, dass eine hohe Integrationsdichte erreicht werden kann, ohne dass zwei Kontakte zu dicht aneinander angeordnet sind. So kann es vermieden werden, dass sich zwei Kontakte in unerwünschter Weise gegenseitig beeinflussen. Durch die Umverdrahtungslage können dementsprechend peripher angeordnete Kontakte der Bauelemente in eine flächige Anordnung auf der jeweiligen Außenfläche umverdrahtet werden, so dass der Kontaktmittenabstand entscheidend vergrößert werden kann.

Die Umverdrahtungslage kann somit eine erhöhte Designflexibilität bei der Anordnung der Kontakte an den Ober- und Unterseiten der Modulbestandteile ermöglichen. Die Umverdrahtungslage kann sehr dünn ausgestaltet werden, insbesondere erheblich dünner als konventionelle Substrate, sodass die Verwendung der Umverdrahtungslage keine wesentliche Erhöhung der Dicke des Moduls nach sich zieht. Umverdrahtungslagen können eine sehr hohe Präzision in der Fertigung aufweisen.

Insbesondere kann jeder der Modulbestandteile auf seiner Oberseite und seiner Unterseite eine Umverdrahtungslage aufweisen, über die er in dem Stapel mit dem jeweils benachbarten Modulbestandteil kontaktiert ist. Zumindest einer von zwei übereinander gestapelten Modulbestandteilen kann eine Umverdrahtungslage aufweisen, die auf der dem jeweils anderen Modulbestandteil zuweisenden Seiten angeordnet ist.

Zumindest einer der Modulbestandteile kann auf seiner Unterseite und auf seiner dieser gegenüberliegenden Oberseite jeweils eine Umverdrahtungslage aufweisen, wobei die Umverdrahtungslagen mit einer Durchkontaktierung verbunden sind, die sich durch das Modulbestandteil erstreckt.

Die Durchkontaktierung ermöglicht eine elektrische Kontaktierung der beiden Umverdrahtungslagen. Bei der Durchkontaktierung kann es sich um sogenannte Embedded-Z-Lines handeln. Embedded-Z-Lines sind dünne Kupfer aufweisende Streifen, die sich von der Unterseite des unteren Modulbestandteils zur Oberseite des unteren Modulbestandteils erstrecken.

Alternativ oder ergänzend zu der Durchkontaktierung können spezielle Bauteile mit vertikalen elektrischen Leitungsverbindungen oder eine Strukturierung von Kontakten an den Modulaußenkanten zur Kontaktierung einer Unterseite eines Modulbestandteils mit einer Oberseite des Modulbestandteils verwendet werden. Denkbar sind auch andere übliche Methoden um elektrisch leitende Einschnitte zur Kontaktierung einer Unterseite eines Modulbestandteils mit einer Oberseite des Modulbestandteils zu erzeugen.

In einem Ausführungsbeispiel kann der untere Modulbestandteil auf seiner dem oberen Modulbestandteil zugewandten Oberseite eine Umverdrahtungslage aufweisen, die eine Metallschicht aufweist, über die der untere Modulbestandteil mit dem oberen Modulbestandteil elektrisch kontaktiert ist.

In einem Ausführungsbeispiel kann der untere Modulbestandteil auf seiner von dem oberen Modulbestandteil wegweisenden Unterseite eine weitere Umverdrahtungslage aufweisen, die mit einer Durchkontaktierung verbunden ist, über die die weitere Umverdrahtungslage mit der auf der Oberseite des unteren Modulbestandteils angeordneten Umverdrahtungslage elektrisch kontaktiert ist.

In einem Ausführungsbeispiel kann der obere Modulbestandteil auf seiner dem unteren Modulbestandteil zugewandten Unterseite eine Umverdrahtungslage aufweist, die eine Metallschicht aufweist, über die der obere Modulbestandteil mit dem unteren Modulbestandteil elektrisch kontaktiert ist.

Das erste Bauelement und/oder das zweite Bauelement kann ein mit akustischen Wellen arbeitendes Filter sein. Ein solches Bauelement weist üblicherweise eine Kavität auf. Das Bauelement kann ein Gehäuse aufweisen, innerhalb dem die Kavität ausgebildet ist, wobei das Gehäuse in dem Material eingebettet ist. Aufgrund der kurzen Signalwege, die sich durch den hohen Integrationsgrad des Moduls ergeben, können mehrere mit akustischen Wellen arbeitende Filter in dem Modul miteinander verschaltet werden und es kann sich durch eine Reduzierung der parasitären Induktivitäten eine Verbesserung der Filtereigenschaften ergeben.

Der untere Modulbestandteil kann auf seiner dem oberen Modulbestandteil zugewandten Oberseite Metallsäulen aufweisen. Der obere Modulbestandteil kann auf seiner dem unteren Modulbestandteil zugewandten Unterseite ebenfalls Metallsäulen aufweisen. Die Metallsäulen des unteren Modulbestandteils und die Metallsäulen des oberen Modulbestandteils können miteinander verbunden sein.

Die Metallsäulen können insbesondere durch eutektisches Bonden verbunden sein. Dabei können die Metallsäulen Kupfer aufweisen, das mit einer Zinn aufweisenden Schicht bedeckt ist. Kupfer und Zinn eignen sich zum eutektischen Bonden. Eutektisches Bonden kann mit einer hohen Präzision durchgeführt werden und erfordert insbesondere nur Strukturen mit einer sehr geringen Höhe. Dementsprechend kann beispielsweise gegenüber der Verwendung von Lötkugeln zur Verbindung die Präzision erhöht werden und gleichzeitig die Höhe der Verbindungsstrukturen reduziert werden. Außerdem kann die flächige Ausdehnung der Metallsäulen geringer sein als die minimal mögliche flächige Ausdehnung einer Lötkugel.

Auf einer Außenfläche des Moduls kann eine Metallisierung angeordnet sein, die eine elektromagnetische Abschirmung des Moduls ermöglicht und/oder die zur Wärmeabfuhr von dem Modul dient. Die Metallisierung kann ferner eine Antennenstruktur ausbilden.

Auf der Oberseite des oberen Modulbestandteils, die vom unteren Modulbestandteil weg weist, kann zumindest ein weiterer Modulbestandteil angeordnet sein, der ein Material aufweist, in das zumindest ein drittes Bauelement eingebettet ist. Auf diese Weise kann eine nahezu beliebige Anzahl von Modulbestandteilen übereinandergestapelt werden. Dadurch kann der Integrationsgrad in die dritte Dimension des Moduls stets weiter erhöht werden. Ferner kann zwischen je zwei Modulbestandteilen jeweils zumindest eine Umverdrahtungslage angeordnet sein, durch die die beiden Modulbestandteile elektrisch miteinander kontaktiert sind.

Bei dem Material, in dem das erste und das zweite Bauelement eingebettet sind, kann es sich um ein Prepreg-Material handeln. Dieses zeichnet sich insbesondere durch sein gutes Fließverhalten aus. Es ermöglicht eine einfache Lagenbildung sowie eine Kaschierung mehrerer Lagen miteinander.

Bei dem ersten und/oder dem zweiten Bauelement kann es sich um eines ausgewählt aus einem Halbleiterchip mit einer integrierten aktiven oder passiven Schaltung, einem passiven Bauelement, einem Sensor, einem digitalen Chip oder einem MEMS-Bauelement handeln. Neben dem eigentlichen Sensorelement kann ein solcher Sensor auch eine Logik zur Auswertung der gemessenen Messdaten sowie ein Speicherelement aufweisen. Diese Vielfalt an möglichen Bauelementen zeigt, dass das Modul eine Technologieplattform zur Kombination verschiedenster Bauelementtypen sein kann.

Der obere Modulbestandteil kann auf seiner von dem unteren Modulbestandteil wegweisenden Oberseite eine Umverdrahtungslage aufweisen, die eine Metallisierung aufweist, die sowohl eine Antennenstruktur als auch passive Elemente, die mit dem zweiten Bauelement verschaltet sind, ausbildet. Die Metallisierung dient somit einer Vielzahl von Zwecken gleichzeitig.

Nachfolgend wird ein beispielhaftes Verfahren zur Herstellung einer Vielzahl von Modulen erläutert. Dies kann hilfreich sein für das Verständnis der Erfindung, auch wenn kein Verfahren beansprucht ist. Bei den Modulen kann es sich um die oben beschriebenen Module handeln. Dementsprechend kann jedes strukturelle und funktionelle Merkmal, das im Zusammenhang mit dem Modul offenbart wurde, auch auf das Verfahren zutreffen. Jedes im Zusammenhang mit dem Verfahren offenbarte Merkmal kann auch auf die oben beschriebenen Module zutreffen.

Es wird ein Verfahren zur Herstellung einer Vielzahl von Modulen, die jeweils einen unteren Modulbestandteil, der ein Material aufweist, in das zumindest ein erstes Bauelement eingebettet ist, und einen oberen Modulbestandteil, der ein Material aufweist, in das zumindest ein zweites Bauelement eingebettet ist, wobei der obere Modulbestandteil und der untere Modulbestandteil übereinander gestapelt sind, und wobei der untere und der obere Modulbestandteil elektrisch miteinander kontaktiert sind und mechanisch miteinander verbunden sind, beschrieben. Das Verfahren weist die folgenden Schritte auf:
- Fertigen eines unteren Wafers oder eines unteren Panels, in dem eine Vielzahl von unteren Modulbestandteilen im Verbund angeordnet sind,
- Fertigen eines oberen Wafers oder eines oberen Panels, in dem eine Vielzahl von oberen Modulbestandteilen im Verbund angeordnet sind,
- Befestigen des unteren Wafers an dem oberen Wafer oder Befestigen des unteren Panels an dem oberen Panel, und
- Vereinzeln der Module.

Die Schritte werden vorzugsweise in der hier angegebenen Reihenfolge durchgeführt. Dementsprechend können eine Vielzahl der Schritte durchgeführt werden, während die Module in einem Waferverbund bzw. einem Panelverbund vorliegen. Im Verbund lässt sich eine Vielzahl von Modulen in gemeinsamen Arbeitsschritten gleichzeitig bearbeiten. Daher kann auf diese Weise die Herstellung erheblich vereinfacht werden. Da die Vereinzelung der Module erst nach dem Befestigen der Modulbestandteile aneinander erfolgt, kann insbesondere eine aufwendige Einzelhandhabung der Modulbestandteile vermieden werden.

Der untere und der obere Wafer oder das untere und das obere Panel können insbesondere mittels eutektischem Bonden, einer elektrisch leitenden Klebeverbindung, Sintern oder Löten miteinander verbunden werden. Insbesondere eine Verbindung mittels eutektischem Bonden bietet zahlreiche Vorteile, da diese Verbindungstechnik mit hoher Präzision durchgeführt werden kann.

Bei der Fertigung des unteren Wafers oder des unteren Panels können die ersten Bauelemente in einem Sheet-Molding Verfahren einseitig in dem Material eingebettet werden, wobei das Material als Folie auflaminiert wird. Bei der Fertigung des oberen Wafers oder des oberen Panels können die zweiten Bauelemente in einem Sheet-Molding Verfahren einseitig in dem Material eingebettet werden, wobei das Material als Folie auflaminiert wird.

Bei der Fertigung des unteren Wafers oder des unteren Panels können die ersten Bauelemente in einem Vakuumlaminierpressvorgang in dem Material eingebettet werden und anschließend wird der untere Wafer oder das untere Panel mit einem Isolationsmaterial vernetzt. Bei der Fertigung des oberen Wafers oder des oberen Panels können die zweiten Bauelemente in einem Vakuumlaminierpressvorgang in dem Material eingebettet werden und anschließend wird der obere Wafer oder das obere Panel mit einem Isolationsmaterial vernetzt. Das Isolationsmaterial kann mittels Aufwalzen, Dispenstechnologie, Jetten oder einer Kombination aus diesen Verfahren aufgetragen werden.

Nach dem Befestigen des unteren Wafers oder des unteren Panels an dem oberen Wafer oder dem oberen Panel kann der obere Wafer oder das obere Panel einem Schleifprozess unterzogen werden, in dem eine Dicke des oberen Wafers oder des oberen Panels verringert wird. Dadurch kann die Materialmasse über den Bauteilen auf ein Minimum reduziert werden und die Dicke des Moduls weiter reduziert werden. Es kann auch eine Reihe von Bauteilen gedünnt werden.

Im Folgenden wird die vorliegende Erfindung anhand der beiliegenden Figuren im Detail beschrieben.
Figur 1 zeigt einen unteren Modulbestandteil in einem Querschnitt.
Figur 2 zeigt einen oberen Modulbestandteil in einem Querschnitt.
Figur 3 zeigt ein Modul, das durch ein Stapeln des in Figur 1 gezeigten unteren Modulbestandteils und des in Figur 2 gezeigten oberen Modulbestandteils gefertigt wurde, in einem Querschnitt.
Figur 4 zeigt das in Figur 3 gezeigte Modul nach der Durchführung weiterer Bearbeitungsschritte.
Figur 5 zeigt ein Modul gemäß einem alternativen Ausführungsbeispiel im Querschnitt.

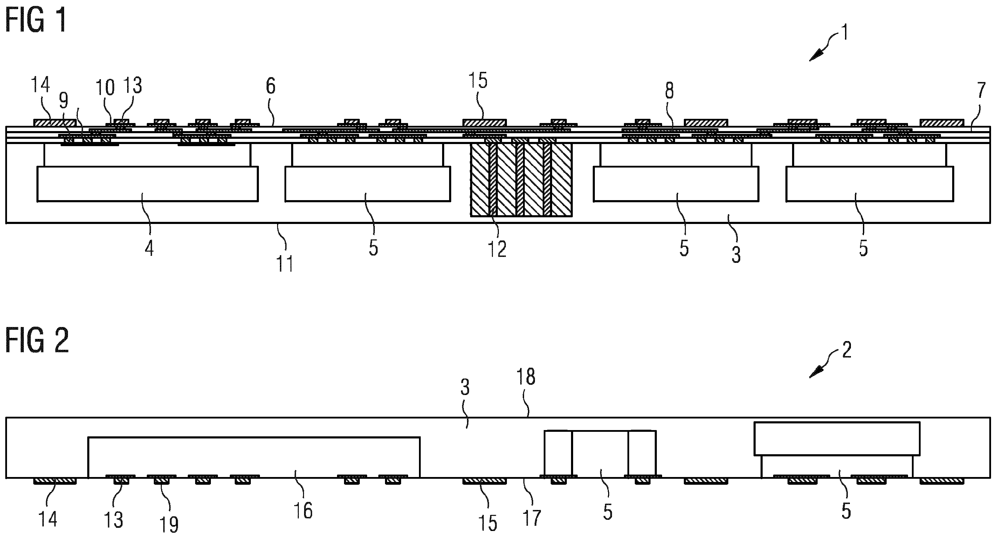

Figur 1 zeigt einen unteren Modulbestandteil **1,** der mit einem oberen Modulbestandteil 2 zu einem Modul verbunden werden kann. In Figur 1 ist ein einziger unterer Modulbestandteil 1 gezeigt. Der untere Modulbestandteil 1 kann zusammen mit einer Vielzahl weiterer unterer Modulbestandteile in einem Waferverbund oder einem Panelverbund gefertigt werden.

Der untere Modulbestandteil 1 weist ein Material 3 auf, in das ein erstes Bauelement 4 sowie weitere Bauelemente 5 eingebettet sind. Bei dem Material 3 kann es sich beispielsweise um ein Molding Material, einen organischen Schichtstoff, insbesondere auf Epoxy- oder Phenolbasis, oder ein Prepregmaterial handeln.

Beispielsweise handelt es sich bei dem ersten Bauelement 4 um ein mit SAW-Wellen arbeitendes Bauelement (SAW = Surface Acoustic Wave). Es handelt sich dementsprechend um ein verkapseltes Bauelement, das einen Hohlraum aufweist. Der untere Modulbestandteil 1 ist derart ausgestaltet, dass verschiedenste Bauelemente **4,** 5 in das Material 3 eingebettet werden können. Er stellt dementsprechend eine Technologieplattform dar, die die Integration verschiedener Bauelemente **4,** 5 in das Modul ermöglicht.

Bei den weiteren Bauelementen 5 kann es sich beispielsweise um Sensorchips handeln, die analog oder digital sein können. Neben dem eigentlichen Sensorelement kann ein solcher Sensorchip auch eine Logik zur Auswertung der gemessenen Messdaten sowie ein Speicherelement aufweisen. Bei den weiteren Bauelementen 5 kann es sich alternativ oder ergänzend um eines oder mehrere ausgewählt aus einem Halbleiterchip mit einer integrierten aktiven oder passiven Schaltung, einem passiven Bauelement, einen digitalen Chip oder einem MEMS-Bauelement handeln.

Auf der Oberseite 6 des unteren Modulbestandteils 1 ist ferner eine Umverdrahtungslage 7 angeordnet. Die Umverdrahtungslage 7 weist eine Metallschicht 8 auf. Die Umverdrahtungslage 7 ist mehrschichtig ausgestaltet, wobei die Metallschicht 8 in mehreren Schichten angeordnet ist. Das erste Bauelement 4 weist mehrere Kontakte 9 auf. Diese sind mit der Metallschicht 8 der Umverdrahtungslage 7 verbunden. Über die Metallschicht 8 werden die Kontakte 9 des ersten Bauelements 4 mit an der Oberseite der Umverdrahtungslage 7 angeordneten Kontakten 10 verbunden. Dadurch kann die Position der Kontakte 10 in beliebiger Weise eingestellt werden. Insbesondere können die Kontakte 9 der Bauelemente **4,** 5 in eine flächige Anordnung auf der Oberseite 6 des unteren Modulbestandteils 1 umverdrahtet werden, so dass der Kontaktmittenabstand entscheidend vergrößert werden kann.

Der in Figur 1 gezeigte untere Modulbestandteil 1 weist keine Umverdrahtungslage an seiner Unterseite 11 auf. Diese wird in einem späteren Verfahrensschritt erzeugt.

Die auf der Oberseite 6 des unteren Modulbestandteils 1 angeordnete Umverdrahtungslage 7 ist mit einer Durchkontaktierung 12 elektrisch verbunden, die sich durch den unteren Modulbestandteil 1 erstreckt.

Ferner sind auf der Oberseite 6 des unteren Modulbestandteils 1 Metallsäulen 13 angeordnet. Die Metallsäulen 13 können beispielsweise aus Kupfer bestehen. Die Metallsäulen 13 sind auf den Kontakten 10 der Umverdrahtungslage 7 angeordnet und dementsprechend mit der Metallschicht 8 der Umverdrahtungslage 7 elektrisch kontaktiert. Die Metallsäulen 13 können im Zusammenspiel mit entsprechenden Metallsäulen auf der Unterseite des oberen Modulbestandteils 2 für eine elektrische Kontaktierung der beiden Modulbestandteile **1, 2** miteinander sorgen.

Auf der Oberseite 6 des unteren Modulbestandteils 1 ist ferner ein Ring 14 angeordnet. Dieser ist aus einem Metall, beispielsweise Kupfer, gefertigt. Der Ring 14 sorgt für eine mechanische Stabilisierung und ist mit einem entsprechenden Ring, der auf einer Unterseite eines oberen Modulbestandteils 2 angeordnet ist, verbunden, beispielsweise durch eutektisches Bonden.

Ferner können auf der Oberseite 6 des unteren Modulbestandteils 1 weitere metallische Strukturen 15, beispielsweise aus Kupfer, angeordnet sein, die für eine mechanische Stabilisierung der mechanischen Verbindung zwischen dem unteren und dem oberen Modulbestandteil 1, 2 sorgen, und die nicht elektrisch angebunden sind.

Der am Rand der Oberseite 6 angeordnete Ring 14 und die in einem Innenbereich der Oberseite 6 angeordneten weiteren metallischen Strukturen 15 sorgen für eine mechanische Verfestigung des unteren Modulbestandteils 1 und eine Vermeidung von Verwölbungen.

Figur 2 zeigt den oberen Modulbestandteil **2.** In Figur 2 ist ein einziger oberer Modulbestandteil 2 gezeigt. Der obere Modulbestandteil 2 kann zusammen mit einer Vielzahl weiterer oberer Modulbestandteile 2 in einem Waferverbund oder einem Panelverbund gefertigt werden.

Der obere Modulbestandteil 2 ist dazu ausgestaltet, mit dem unteren Modulbestandteil 1 zu einem Modul verbunden zu werden. Der obere Modulbestandteil 2 weist einen Aufbau auf, der dem unteren Modulbestandteil 1 ähnlich ist. Auch der obere Modulbestandteil 2 weist ein Material 3 auf, in das ein zweites Bauelement 16 sowie weitere Bauelemente 5 eingebettet sind. Bei dem Material 3 kann es sich beispielsweise um eines der oben genannten Materialien handeln, die auch für den unteren Modulbestandteil 1 verwendet werden. Das Material 3 kann mit dem Material 3 des unteren Modulbestandteils 1 identisch sein oder sich von diesem unterscheiden.

Auch der obere Modulbestandteil 2 bildet eine Plattform zur Integration von verschiedenen Bauelementen 16, 5. Bei dem zweiten Bauelement 16 und den weiteren Bauelementen 5 kann es sich beispielsweise um eines oder mehrere ausgewählt aus einem analogen oder digitalen Chip, einer passiven Komponente oder einem Sensorchip handeln.

Der in Figur 2 gezeigte obere Modulbestandteil 2 weist keine Umverdrahtungslage 7 auf. In alternativen Ausführungsformen kann der obere Modulbestandteil 2 auf seiner Unterseite 17 und/oder auf seiner Oberseite 18 eine ein- oder mehrlagige Umverdrahtungslage 7 aufweisen.

An der Unterseite 17 des oberen Modulbestandteils 2 sind Metallsäulen 13 angeordnet, die mit den Metallsäulen 13 auf der Oberseite 6 des unteren Modulbestandteils 1 verbunden werden können, um die beiden Modulbestandteile **1, 2** elektrisch miteinander zu kontaktieren. Die Metallsäulen 13 bestehen beispielsweise aus Kupfer und weisen auf ihrer zu unteren Modulbestandteil 1 weisenden Seite eine Zinnaufweisenden Beschichtung 19 auf. Die Metallsäulen 13 des unteren Modulbestandteils 1 und die Metallsäulen 13 des oberen Modulbestandteils 2 werden durch eutektisches Bonden verbunden, wobei die Kombination von Kupfer und Zinn eine Verbindung bilden.

Alternativ können die Metallsäulen 13 statt mit Zinn, mit einem leitfähigen Klebematerial beschichtet sein. In diesem Fall können die Metallsäulen 13 mit den entsprechenden Metallsäulen des unteren Modulbestandteils 1 verklebt werden.

An seiner Unterseite 17 weist der obere Modulbestandteil 2 ferner einen Ring 14 auf, der dazu ausgestaltet ist, mit dem Ring 14 des unteren Modulbestandteils 1 verbunden zu werden. Ferner weist die Unterseite 17 des oberen Modulbestandteils 2 weitere metallische Strukturen 15 auf, die zur Erhöhung einer mechanischen Stabilität des Moduls beitragen. Wie bereits im Zusammenhang mit dem unteren Modulbestandteil 1 diskutiert, sorgen der Ring 14 und die weiteren metallischen Strukturen 15 für eine mechanische Verfestigung und eine Vermeidung von Verwölbungen des oberen Modulbestandteils **2.** Auch der Ring 14 und die weiteren metallischen Strukturen 15 sind mit Zinn beschichtet, um eine Verbindung durch eutektisches Bonden zu ermöglichen. Alternativ können diese Elemente beispielsweise mit einem Kleber beschichtet werden. Alternativ zu einer Verbindung durch eutektisches Bonden sind auch andere Verbindungsprozesse möglich, beispielsweise ein Ag-Sinterprozess oder Verlöten.

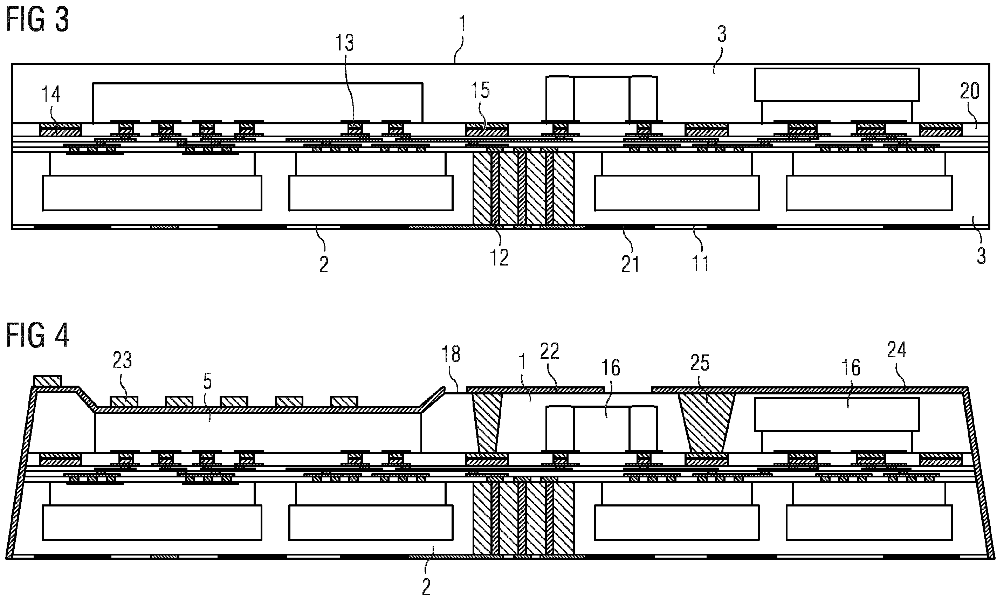

Figur 3 zeigt das Modul, nachdem der untere Modulbestandteil 1 aus Figur 1 an dem oberen Modulbestandteil 2 aus Figur 2 befestigt wurde. Dabei wird ein Wafer oder ein Panel, das eine Vielzahl unterer Modulbestandteile 1 aufweist, an einem Wafer oder Panel, das eine entsprechende Vielzahl oberer Modulbestandteile 2 aufweist, befestigt.

Die beiden Modulbestandteile 1, 2 wurden durch eutektisches Bonden miteinander verbunden. Dieser Schritt wurde durchgeführt während die beiden Modulbestandteile 1, 2 jeweils mit einer Vielzahl weiterer Modulbestandteile 1, 2 in einem Waferverbund oder einem Panelverbund verbunden sind. Bei dem eutektischen Bonden wurden die Ringe 14, die Metallsäulen 13 und die weiteren metallischen Strukturen 15 miteinander verbunden. Die Metallsäulen 13 sorgen für eine elektrische Kontaktierung der beiden Modulbestandteile 1, 2 miteinander. Die Ringe 14 sowie die weiteren metallischen Strukturen 15 sind mechanisch miteinander verbunden und erhöhen die mechanische Stabilität des Moduls und verhindern so eine Verwölbung des Moduls.

Zwischen den beiden Modulbestandteilen 1, 2 wurde ferner eine elektrisch isolierende Unterfüllschicht 20 angeordnet. Die Unterfüllschicht 20 kann aus einem konventionellen Material oder einem anisotropischen Leitkleber bestehen. Sie weist keine Lufteinschlüsse oder Hohlstellen auf. Die Unterfüllschicht 20 wird durch die Strukturen zur elektrischen und mechanischen Verbindung der Modulbestandteile 1, 2 unterbrochen. Hierzu gehören insbesondere die Ringe 14, die weiteren metallischen Strukturen 15 und die Metallsäulen 13.

Die Unterfüllschicht 20 sorgt dafür, dass die Unterseite 17 des oberen Modulbestandteils 2 und die Oberseite 6 des unteren Modulbestandteils 1 jeweils eine einheitliche Oberfläche ohne Stufen aufweisen. Die Verbindung der beiden Modulbestandteile 1, 2 kann durch die Unterfüllschicht 20 versiegelt werden.

Ferner wurde Material 3 von der Unterseite 11 des unteren Modulbestandteils 1 abgetragen, um die nach unten weisenden Enden der Durchkontaktierung 12 freizulegen. Anschließend wurde auf der Unterseite 11 des unteren Modulbestandteils 1 eine Kontaktierungsschicht 21 aufgebracht. Diese ermöglicht es, dass Modul mit einer Leiterplatte oder ähnlichem zu kontaktieren.

Das Abtragen des Materials 3 von der Unterseite 11 des unteren Modulbestandteils 1 wurde erst nach dem Verbinden des unteren Modulbestandteils 1 mit dem oberen Modulbestandteil 2 durchgeführt, da das Modul danach eine erhöhte mechanische Stabilität aufweist, so dass bei dem Materialabtrag die Gefahr eines Brechens des Moduls recht gering ist.

Figur 4 zeigt das in Figur 3 gezeigte Modul nach der Durchführung weitere Schritte des Herstellungsverfahrens.

Die Module, die in Figur 3 in einem Wafer- oder Panelverbund vorlagen, wurden nunmehr vereinzelt, beispielsweise durch einen Sägeprozess. Dadurch haben sich die in Figur 4 gezeigten schrägen Seitenflächen des Moduls ergeben.

Ferner wurde Material 3 von der Oberseite 18 des oberen Modulbestandteils 2 abgetragen. Insbesondere wurde der obere Modulbestandteil 2 durch einen Schleifprozess ausgedünnt. Dabei wurde die Dicke der Materialien 3 über den Bauelementen 5, 16 reduziert. Ferner wurden Einschnitte eingefügt, die für Durchkontaktierungen genutzt werden.

Auf der Oberseite 18 des oberen Modulbestandteils 2 sind Metallisierungen 22, 23, 24 aufgebracht. Die Metallisierung 22 bildet eine Antennenstruktur aus. Die Metallisierung 23 dient zur Kühlung des Moduls. Die Metallisierung 24 dient zum Schutz vor elektrostatischen Entladungen. Ferner ist ein thermisches Via 25 vorgesehen, das dazu dienen soll, von dem Modul erzeugte Hitze zur Oberseite 18 abzuleiten.

Das zweite Bauelement 16 wurde bei dem Ausdünnen freigelegt, so dass seine Oberseite nicht von dem Material 3 bedeckt ist. Stattdessen ist auf der Oberseite des zweiten Bauelements 16 nunmehr die Metallisierung 23 angeordnet, die zur Kühlung des zweiten Bauelements 16 dient.

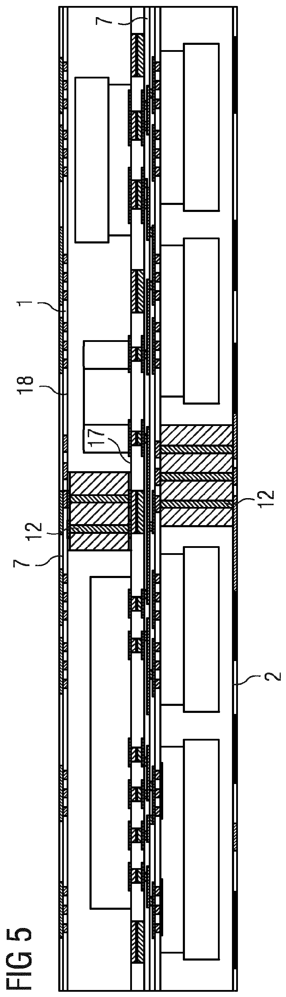

Figur 5 zeigt ein Modul gemäß einem alternativen Ausführungsbeispiel. Das in Figur 5 gezeigte Modul unterscheidet sich von vorher gezeigten Modul dadurch, dass auf der Oberseite 18 des oberen Modulbestandteils 2 eine Umverdrahtungslage 7 angeordnet ist und dass in dem oberen Modulbestandteil 2 Durchkontaktierungen 12 vorgesehen sind, die die auf der Oberseite 18 des oberen Modulbestandteils 2 angeordnete Umverdrahtungslage 7 mit einem auf der Unterseite 17 angeordneten Kontakt kontaktiert. Die Durchkontaktierungen 12 sind Embedded-Z-Lines.

Die auf der Oberseite 18 des oberen Modulbestandteils 2 angeordnete Umverdrahtungslage 7 bildet eine Antennenstruktur aus.

Bei dem in Figur 5 gezeigten Modul wurde der obere Modulbestandteil 2 nicht gedünnt.

## Patentansprüche

1. Modul, aufweisend
einen unteren Modulbestandteil (1), der ein Material (3) aufweist, in das zumindest ein erstes Bauelement (4) eingebettet ist, und einen oberen Modulbestandteil (2), der ein Material (3) aufweist, in das zumindest ein zweites Bauelement (16) eingebettet ist, wobei das Material (3), in welches das erste und das zweite Bauelement (4, 16) eingebettet sind, ausgewählt ist aus: Prepreg-Material, Molding-Material, Glassubstrat, Keramiksubstrat, oder PCB Substrat, und wobei das Material (3) für das erste Bauelement (4) und das Material (3) für das zweite Bauelement (16) identisch oder verschieden sein kann; wobei der obere Modulbestandteil (2) und der untere Modulbestandteil (1) übereinander gestapelt sind,
wobei der untere und der obere Modulbestandteil (2) elektrisch miteinander kontaktiert sind und mechanisch miteinander verbunden sind, wobei ein Metallring (14) an einer Oberseite (6) des unteren Modulbestandteils (1) mit einem Metallring (14) an einer Unterseite des oberen Modulbestandteils (2) verbunden ist; und
a. wobei zumindest der untere Modulbestandteil (1) auf einer dem oberen Modulbestandteil (2) zugewandten Seite eine Umverdrahtungslage (7) aufweist, die eine Metallschicht (8) aufweist, über die die Modulbestandteile (1, 2) miteinander elektrisch kontaktiert sind, wobei das erste Bauelement (4) über eine Mehrzahl von Kontakten (9) mit der Metallschicht (8) verbunden ist, oder
b. wobei zumindest der obere Modulbestandteil (2) auf einer dem unteren Modulbestandteil (1) zugewandten Seite eine Umverdrahtungslage (7) aufweist, die eine Metallschicht (8) aufweist, über die die Modulbestandteile (1, 2) miteinander elektrisch kontaktiert sind, wobei das zweite Bauelement (16) über eine Mehrzahl von Kontakten (9) mit der Metallschicht (8) verbunden ist.

2. Modul gemäß dem vorherigen Anspruch,
wobei zumindest einer der Modulbestandteile (1, 2) auf seiner Unterseite (11, 17) und auf seiner dieser gegenüberliegenden Oberseite (6, 18) jeweils eine Umverdrahtungslage (7) aufweist, wobei die Umverdrahtungslagen (7) mit einer Durchkontaktierung (12) verbunden sind, die sich durch den Modulbestandteil (1, 2) erstreckt.

3. Modul gemäß einem der vorherigen Ansprüche,
wobei es sich bei dem ersten und/oder dem zweiten Bauelement (4, 16) um eines ausgewählt aus einem Halbleiterchip mit einer integrierten aktiven oder passiven Schaltung, einem passiven Bauelement, einem Sensor, einem digitalen Chip oder einem MEMS Bauelement handelt.

## Claims

1. A module, comprising
a lower module component (1), which comprises a material (3), in which at least one first element (4) is embedded, and an upper module component (2), which comprises a material (3), in which at least one second element (16) is embedded, wherein the material (3), in which the first and the second element (4, 16) are embedded, is selected from: prepreg material, molding material, glass substrate, ceramic substrate, or PCB substrate, and wherein the material (3) for the first element (4) and the material (3) for the second element (16) can be identical or different;
wherein the upper module component (2) and the lower module component (1) are stacked on top of each other,
wherein the lower and the upper module component (2) are electrically contacted with each other and are mechanically connected with each other, wherein a metal ring (14) on an upper side (6) of the lower module component (1) is connected with a metal ring (14) on a lower side of the upper module component (2); and
a. wherein at least the lower module component (1) comprises, on a side facing the upper module component (2), a rewiring layer (7), which comprises a metal layer (8), via which the module components (1, 2) are electrically contacted with each other, wherein the first element (4) is connected with the metal layer (8) via a plurality of contacts (9), or
b. wherein at least the upper module component (2) comprises, on a side facing the lower module component (1), a rewiring layer (7), which comprises a metal layer (8), via which the module components (1, 2) are electrically contacted with each other, wherein the second element (16) is connected with the metal layer (8) via a plurality of contacts (9).

2. The module according to the preceding claim,
wherein at least one of the module components (1, 2) comprises a rewiring layer (7) on its lower side (11, 17) and on its upper side (6, 18) opposite thereto, wherein the rewiring layers (7) are connected with a through-connection (12), which extends through the module component (1, 2).

3. The module according to one of the preceding claims,
wherein the first and/or the second element (4, 16) is one selected from a semiconductor chip with an integrated active or passive circuit, a passive element, a sensor, a digital chip or an MEMS element.

## Revendications

1. Module, comportant :
un élément de module inférieur (1) qui comporte un matériau (3) au sein duquel est intégré au moins un premier composant (4), et un élément de module supérieur (2) qui comporte un matériau (3) au sein duquel est intégré au moins un deuxième composant (16), dans lequel le matériau (3) au sein duquel sont intégrés le premier et le deuxième composant (4, 16) est sélectionné parmi : matériau préimprégné, matériau de moulage, substrat de verre, substrat céramique ou substrat de PCB, et dans lequel le matériau (3) pour le premier composant (4) et le matériau (3) pour le deuxième composant (16) peuvent être identiques ou différents ;
dans lequel l'élément de module supérieur (2) et l'élément de module inférieur (1) sont empilés l'un sur l'autre, dans lequel l'élément de module inférieur et l'élément de module supérieur (2) sont mis en contact électrique l'un avec l'autre et sont reliés mécaniquement l'un à l'autre, dans lequel un anneau métallique (14) sur une face supérieure (6) de l'élément de module inférieur (1) est reliée à un anneau métallique (14) sur une face inférieure de l'élément de module supérieur (2) ; et
a. dans lequel au moins l'élément de module inférieur (1) comporte, sur une face orientée vers l'élément de module supérieur (2), une strate de recâblage (7) qui comporte une couche métallique (8) par laquelle les éléments de module (1, 2) sont mis en contact électrique l'un avec l'autre, dans lequel le premier composant (4) est relié à la couche métallique (8) par une pluralité de contacts (9), ou
b. dans lequel au moins l'élément de module supérieur (2) comporte, sur une face orientée vers l'élément de module inférieur (1), une strate de recâblage (7) qui comporte une couche métallique (8) par laquelle les éléments de module (1, 2) sont mis en contact électrique l'un avec l'autre, dans lequel le deuxième composant (16) est relié à la couche métallique (8) par une pluralité de contacts (9).

2. Module selon la revendication précédente,
dans lequel au moins l'un des éléments de module (1, 2) comporte une strate de recâblage (7) respectivement sur sa face inférieure (11, 17) et sur sa face supérieure (6, 18) opposée à celle-ci, dans lequel les strates de recâblage (7) sont reliées à un via d'interconnexion (12) qui s'étend à travers l'élément de module (1, 2).

3. Module selon l'une quelconque des revendications précédentes,
dans lequel le premier et/ou le deuxième composant (4, 16) sont sélectionnés parmi une puce semi-conductrice avec un circuit actif ou passif intégré, un composant passif, un capteur, une puce numérique ou un composant MEMS.
